# EUROPEAN PATENT APPLICATION

(11) **EP 2 811 303 A1**
(43) Date of publication of application: **10.12.2014**
(21) Application number: 14170218.3
(22) Date of filing: 28.05.2014
(51) Int. Cl.: G01R 1/067, G01R 31/28

(54) **Circuit board inspection apparatus, circuit board inspection method and circuit board inspection tool**

(30) Priority: 04.06.2013 JP 2013117883
(71) Applicant: Nidec-Read Corporation, Kyoto-shi, Kyoto 615-0854 (JP)
(72) Inventor: Yamashita, Munehiro, Kyoto 615-0854 (JP)
(74) Representative: Viering, Jentschura & Partner Patent- und Rechtsanwälte

(57) **Abstract**

A circuit board inspection apparatus configured to perform electrical inspection of wiring patterns formed on a circuit board (90) with a built-in electronic component (95) is provided with a plurality of contactors (12), a switching circuit (20), and a controller (30). The controlling device (30) applies voltage by using a power supply (31) between a contactor (12a) and a contactor (12h) in a state a switch (SW1) of the switching circuit (20) is set to be ON and inspects an insulating state between two wiring patterns PT1 and PT2 corresponding to two inspection points (93a) and (93h) on the circuit board (90). At this time, if forward bias is applied to and forward current flows in diodes (21a) and (22h) inserted between the contactor (12a) and the contactor (12h) outside the circuit board (90), a potential difference between the contactors becomes equal to a potential difference VA2 between the diodes (21a) and (22h) and is limited to a relatively small value VL2.

## Description

### BACKGROUND OF THE INVENTION

### 1. Field of the Invention

The present invention relates to a circuit board inspection apparatus configured to perform electrical inspection of writing patterns formed on a circuit board or a substrate with a built-in electronic component (or IC, etc.), and a technology related to the same.

### 2. Description of the Related Art

Currently, a circuit board with a built-in electronic component (or an embedded substrate) in which an electronic component including a diode and a capacitor is built has begun to be widespread.

The method of inspecting the circuit board with the built-in electronic component as described above has not been established yet, but there is a method described in Patent document 1 as one method.

Patent Document 1: Japanese Patent Application Laid Open No. 2007-309814

By the way, when the circuit board with the built-in electronic component is inspected, inspection voltage is set to be relatively low according to wires connected to the electronic component in advance, in order not to damage the electronic component.

On the other hand, even between two terminals on the circuit board with the built-in electronic component, the inspection voltage is preferably set to be relatively high between terminals of wires (or wiring patterns) not connected to the electronic component, in order to improve the quality of the inspection or for a similar purpose.

Regarding the circuit board with the built-in electronic component as described above, various inspections are performed in a state in which an inspection condition is set including inspection voltage or the like appropriate for each of the inspections regarding a plurality of terminals.

If, however, the inspection condition set for the circuit board inspection apparatus is wrong, high voltage is incorrectly applied between the terminals connected to the electronic component, and the electronic component built in the circuit board as an inspection object (or the circuit board with the built-in electronic component) is damaged, which is problematic.

### SUMMARY OF THE INVENTION

It is therefore an object of the present invention to provide a circuit board inspection apparatus configured to prevent the damage of the electronic component built in the circuit board as the inspection object, and a technology relate to the same.

In order to solve the aforementioned problem, an invention of claim 1 is a circuit board inspection apparatus configured to perform electrical inspection of wiring patterns formed on a circuit board with a built-in electronic component, the circuit board inspection apparatus provided with: a first contactor configured to be brought into contact with a first inspection point on the circuit board, the first inspection point being electrically connected to a first terminal of the electronic component; a second contactor configured to be brought into contact with a second inspection point on the circuit board, the second inspection point being electrically connected to a second terminal of the electronic component; and a controlling device configured to apply voltage between the first contactor and the second contactor by using a power supply and to inspect an insulating state between a first wiring pattern electrically connected to the first inspection point and a second wiring pattern electrically connected to the second inspection point, wherein the controlling device applies the voltage between the first contactor and the second contactor in a state in which forward bias is applied to a diode inserted between the first contactor and the second contactor outside the circuit board, and inspects the insulating state between the first wiring pattern and the second wiring pattern in such a manner that a potential difference between the first contactor and the second contactor is equal to a potential difference between ends of the diode when forward current flows in the diode.

An invention of claim 2 is the circuit board inspection apparatus according to claim 1, wherein the controlling device applies the voltage between the first contactor and the second contactor and inspects the insulating state between the first wiring pattern and the second wiring pattern, in a state in which a first diode is inserted between the first contactor and the second contactor in a first direction outside the circuit board and a second diode is inserted between the first contactor and the second contactor in parallel with the first diode in a second direction which is opposite to the first direction outside the circuit board.

An invention of claim 3 is the circuit board inspection apparatus according to claim 1, further provided with a switching circuit disposed between the first contactor and the second contactor outside the circuit board, and configured to switch between a first state in which the forward current flows in the diode inserted between the first contactor and the second contactor outside the circuit board to form a diversion circuit between the first contactor and the second contactor, and a second state in which the diversion circuit is blocked between the first contactor and the second contactor, wherein in a situation in which the first state is selected by the switching circuit, the controlling device applies the voltage between the first contactor and the second contactor in the state in which the forward bias is applied to the diode inserted between the first contactor and the second contactor, and inspects the insulating state between the first wiring pattern and the second wiring pattern in such a manner that the potential difference between the first contactor and the second contactor is equal to the potential difference between ends of the diode when the forward current flows in the diode.

An invention of claim 4 is the circuit board inspection apparatus according to claim 3, wherein in the switching circuit, in the first state, a first diode is inserted between the first contactor and the second contactor in a first direction and a second diode is inserted between the first contactor and the second contactor in parallel with the first diode in a second direction which is opposite to the first direction, and the controlling device applies the voltage between the first contactor and the second contactor in the situation in which the first state is selected by the switching circuit, thereby applying the forward bias to one of the first diode and the second diode, and inspects the insulating state between the first wiring pattern and the second wiring pattern in such a manner that the potential difference between the first contactor and the second contactor is equal to the potential difference between ends of the one diode when the forward current flows in the one diode.

An invention of claim 5 is the circuit board inspection apparatus according to claim 1, further provided with a switching circuit disposed between a plurality of contactors including the first contactor and second contactor outside the circuit board, and configured to switch between a first state in which the forward current flows in each diode disposed between respective one of a plurality of contactor pairs regarding the plurality of contactors to form a diversion circuit between the respective one of the plurality of contactor pairs, and a second state in which the diversion circuit is blocked between the respective one of the plurality of contactor pairs, wherein in a situation in which the first state is selected by the switching circuit, the controlling device applies the voltage between one of the plurality of contactor pairs in the state in which the forward bias is applied to the each diode inserted between the respective one of the plurality of contactor pairs, and inspects an insulating state between two wiring patterns connected to respective two inspection points associated with the one contactor pair.

An invention of claim 6 is the circuit board inspection apparatus according to any one of claims 3 to 5, further provided with a third contactor configured to be brought into contact with a third inspection on the circuit board, the third inspection point being not electrically connected to the electronic component, wherein the controlling device applies the voltage between the first contactor and the third contactor while the first state is continued, and inspects an insulating state between the first wiring pattern connected to the first inspection point and a third wiring pattern connected to the third inspection point.

An invention of claim 7 is the circuit board inspection apparatus according to claim 5, wherein the switching circuit has a switch configured to simultaneously switch between first state and the second state for the plurality of contactor pairs.

An invention of claim 8 is the circuit board inspection apparatus according to any of claims 3 to 7, wherein the first wiring pattern and the second wiring pattern are connected via an internal diode inside the electronic component, and the controlling device performs conduction inspection between the first inspection point and the second inspection point in a situation in which the second state is selected by the switching circuit.

An invention of claim 9 is a circuit board inspection tool used in performing electrical inspection of wiring patterns formed on a circuit board with a built-in electronic component, the circuit board inspection tool provided with: a first contactor configured to be brought into contact with a first inspection point on the circuit board, the first inspection point being electrically connected to a first terminal of the electronic component; a second contactor configured to be brought into contact with a second inspection point on the circuit board, the second inspection point being electrically connected to a second terminal of the electronic component; and a diversion circuit having a diode inserted between the first contactor and the second contactor outside the circuit board, and configured to set a potential difference between the first contactor and the second contactor to be equal to a potential difference between ends of the diode, when forward bias is applied to the diode due to application of voltage between the first contactor and the second contactor by using a power supply and forward current flows in the diode.

An invention of claim 10 is a circuit board inspection method of performing electrical inspection of wiring patterns formed on a circuit board with a built-in electronic component, the circuit board inspection method provide with: a) a step of forming a first state in which a diversion circuit is configured outside the circuit board, the diversion circuit having a diode inserted between a first contactor and a second contactor, the first contactor being configured to be brought into contact with a first inspection point on the circuit board, the first inspection point being electrically connected to a first terminal of the electronic component, the second contactor being configured to be brought into contact with a second inspection point on the circuit board, the second inspection point being electrically connected to a second terminal of the electronic component; and b) a step of applying voltage between the first contactor and the second contactor by using a power supply in such a manner that a potential difference between the first contactor and the second contactor is equal to a potential difference between ends of the diode when forward current flows in the diode due to application of forward bias to the diode of the diversion circuit, thereby inspecting an insulating state between a first wiring pattern connected to the first inspection point and a second wiring pattern connected to the second inspection point.

An invention of claim 11 is the circuit board inspection method according to claim 10, further provided with: c) a step of applying voltage between the first contactor and a third contactor configured to be brought into contact with a third inspection point on the circuit board, the third inspection point being not electrically connected to the electronic component, in a situation in which the first state is maintained, thereby inspecting an insulating state between the first wiring pattern connected to the first inspection point and a third wiring pattern connected to the third inspection point.

An invention of claim 12 is the circuit board inspection method according to claim 10 or 11, wherein the first wiring pattern and the second wiring pattern are connected via an internal diode inside the electronic component, and the circuit board inspection method is further provided with: d) a step of forming a second state in which the diversion circuit is blocked; and e) a step of performing conduction inspection between the first inspection point and the second inspection point in the second state.

According to the inventions described in claim 1 to claim 12, it is possible to prevent the electronic component built in the circuit board from being damaged by incorrect voltage application in the insulation inspection. [0023]

In particular, according to the inventions described in claim 2 and claim 4, even if the relatively high voltage is incorrectly applied in any direction, current flows in one of the first diode and the second diode, and the potential difference between the ends of the one diode becomes equal to the potential difference between the contactors. It is thus possible to prevent the electronic component built in the circuit board from being damaged by the incorrect voltage application.

In particular, according to the invention described in claim 6, it is possible to prevent the damage of the electronic component caused by that high voltage is incorrectly applied between the first inspection point and the third inspection point, in the insulation inspection between the first inspection point and the third inspection point.

### BRIEF DESCRIPTION OF THE DRAWINGS

FIG. 1 is a schematic diagram illustrating an internal configuration of a circuit board inspection apparatus;
FIG. 2 is a schematic diagram illustrating a configuration of a circuit board inspection tool;
FIG. 3 is a diagram illustrating an electronic circuit (or an inspection circuit) configured to inspect a circuit board;
FIG. 4 is a diagram illustrating voltage-current characteristics of diodes;
FIG. 5 is a diagram illustrating the inspection circuit in which a switching circuit is OFF;
FIG. 6 is a diagram illustrating the inspection circuit in which the switching circuit is ON;
FIG. 7 is a diagram illustrating an equivalent circuit obtained by extracting one portion of FIG. 5;
FIG. 8 is a diagram illustrating an equivalent circuit obtained by extracting one portion of FIG. 6;
FIG. 9 is a diagram illustrating an equivalent circuit obtained by extracting one portion of FIG. 5; and
FIG. 10 is a flowchart illustrating an inspection procedure.

### DETAILED DESCRIPTION OF THE PREFERRED EMBODIMENT

Hereinafter, an embodiment of the present invention will be explained with reference to the drawings.

### <1. Apparatus Configuration Outline>

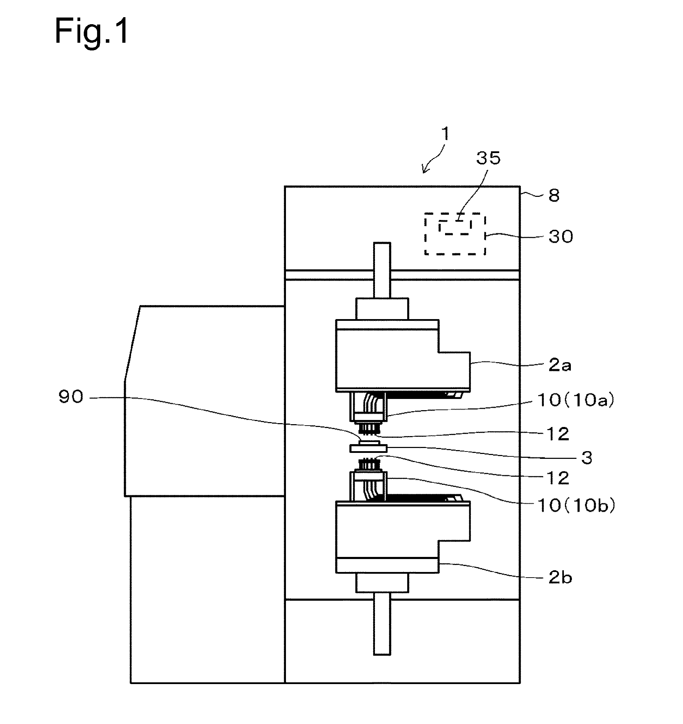

FIG. 1 is a schematic diagram illustrating an internal configuration of a circuit board inspection apparatus 1. The circuit board inspection apparatus 1 is an inspection apparatus configured to perform continuity or conduction inspection and insulation inspection between a plurality of wiring patterns disposed on a substrate or a circuit board 90 as an inspection object. The circuit board inspection apparatus 1 can even set a circuit board in which an electronic component is built (or a circuit board with a built-in electronic component), as the inspection object.

As illustrated in FIG. 1, the circuit board inspection apparatus 1 is provided with a conveying table 3 configured to mount thereon the circuit board 90 as the inspection object, inside a case or a housing 8 in a substantially rectangular parallelepiped shape. The conveying table 3 is supported by a not-illustrated support mechanism and is driven by a not-illustrated drive mechanism in a horizontal direction (or in left and right directions in FIG. 1, etc.).

Over and under the conveying table 3, there are provided tool drive mechanisms 2 (specifically, 2a and 2b). Specifically, a tool drive mechanism 2a is disposed on an upper side in a vertical direction of the conveying table 3, and a tool drive mechanism 2b is disposed on a lower side in the vertical direction of the conveying table 3. Each of the tool drive mechanisms 2a and 2b can move in the vertical direction (or in up and down directions in FIG. 1).

The tool drive mechanisms 2 are provided with circuit board inspection tools 10 (specifically, 10a and 10b). Specifically, a circuit board inspection tool 10a is fixed or held on a lower surface side of the tool drive mechanism 2a, and a circuit board inspection tool 10b is fixed or held on an upper surface side of the tool drive mechanism 2b.

Each of the circuit board inspection tools 10a and 10b is provided with a plurality of (e.g. 100) circuit board inspection contactors (or probes) 12 which abut on terminals (or inspection points) of the wiring patterns of the circuit board 90.

If the circuit board inspection tool 10a moves down according to a lowering operation of the tool drive mechanism 2a, the plurality of contactors 12 on a lower end side of the circuit board inspection tool 10a are brought into contact with the plurality of terminals (also referred to as land or pad electrodes, etc.) disposed on an upper surface side of the circuit board 90, respectively. By applying appropriate pressure at this time, physical and electrical contact is appropriately ensured.

In the same manner, if the circuit board inspection tool 10b moves up according to a rising operation of the tool drive mechanism 2b, the plurality of contactors 12 on an upper end side of the circuit board inspection tool 10b are brought into contact with the plurality of terminals disposed on a lower surface side of the circuit board 90, respectively. By applying appropriate pressure at this time, physical and electrical contact is appropriately ensured. In a central portion of the conveying table 3, there is formed a through opening(s) for bringing the contactors 12 of the circuit board inspection tool 10b into contact with the terminals of the wiring patterns on the lower surface (or rear surface) of the circuit board 90.

As described above, electrical inspection is performed on the wiring patterns formed on the circuit board, in a state in which the contactors 12 of the circuit board inspection tools 10a and 10b are in contact with the upper and lower surfaces (or the front and rear surfaces) of the circuit board 90, respectively.

### <2. Tool>

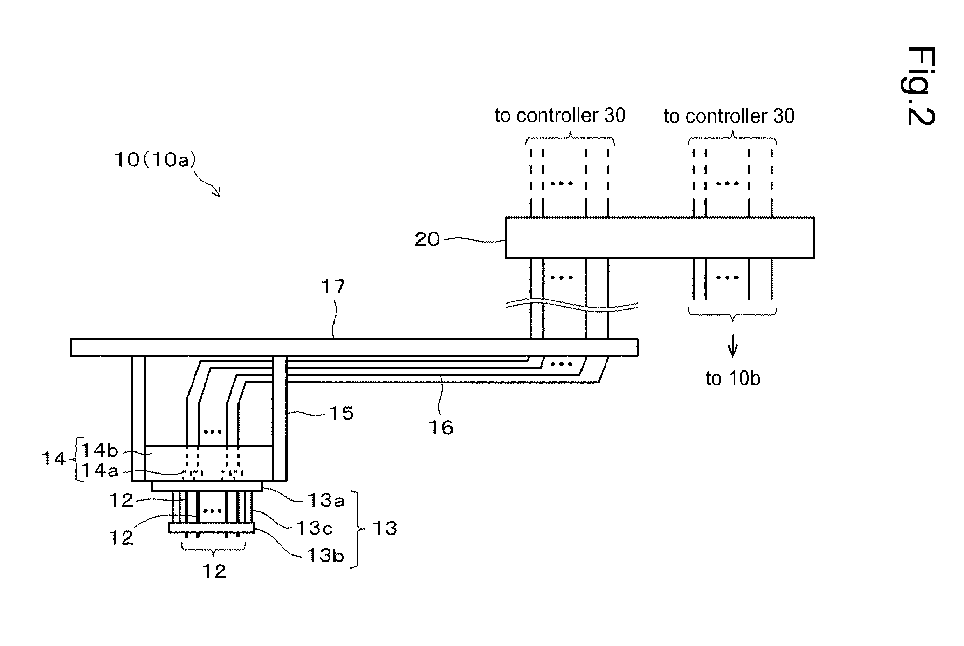

FIG. 2 is a schematic diagram illustrating a configuration of the circuit board inspection tool 10 (or 10a). Here, the circuit board inspection tool 10a is explained; however, the circuit board inspection tool 10b also has the same configuration.

The circuit board inspection tool 10 is provided with the plurality of contactors 12, a holding body 13 configured to hold the plurality of contactors 12, an electrode body 14 having a plurality of electrode units 14a, a support unit 15 configured to support the electrode body 14, a wiring unit 16, a base unit 17, and a switching circuit 20.

Each of the contactors 12 abuts on and is conductively connected to a predetermined inspection point set on the inspection object (or the circuit board) at one end (or a lower end in FIG. 2) of the contactor 12. Each of the contactors 12 also abuts on and is conductively connected to respective one of the electrode units 14a at the other end (or an upper end in FIG. 2) of the contactor 12. The contactors 12 are formed of a conductive material.

The contactor 12 has an elongated rod shape. The contactor 12 is insulating-coated over the entire circumference except the both ends. The contactor 12 has flexibility, and is installed with it slightly bended in a certain direction when it is installed in the holding body 13. The installation of the contactor 12 with it bended as described above causes resilience. According to the resilience, pressing force or the like is generated from the capacitor 12 to the inspection point.

The holding body 13 guides one ends (or lower ends) of the plurality of contactors 12 to respective predetermined inspection points, and guides the other ends (or upper ends) to respective predetermined electrode units 14a. The holding body 13 has an electrode-side plate unit 13a, an inspection-side plate unit 13b, and braces 13c. The electrode-side plate unit 13a and the inspection-side plate unit 13b are fixed by using the predetermined number of braces 13c while the units 13a and 13b are away from each other. The contactors 12 are bended in a space between the electrode-side plate unit 13a and the inspection-side plate unit 13b.

The electrode-side plate unit 13a is formed of an insulation material, and has a through hole(s) (or guiding hole(s)) for guiding the other ends (or upper ends) of the contactors 12 to the electrode units 14a.

The inspection-side plate unit 13b is formed of an insulation material, and has a through hole(s) (or guiding hole(s)) for guiding one ends (or lower ends) of the contactors 12 to the inspection points. The contactors 12 project from the through hole(s) of the inspection-side plate unit 13b. In the inspection, the tips of the contactors 12 abut on the inspection points of the circuit board 90.

The electrode body 14 has the plurality of electrode units 14a which are in conductive contact with the other ends (or upper ends) of the plurality of contactors 12, and an electrode holding unit 14b configured to hold the plurality of electrode units 14a. The electrode units 14a are formed to be disposed in predetermined positions on the surface side (or lower surface side herein) of the electrode body 14, and is connected (more specifically, electrically connected (which applies hereinafter)) to the wiring unit 16 from the rear surface (or upper surface) side of the electrode body 14. The electrode holding unit 14b is formed of an insulation material in a plate shape, and has a plurality of through holes (not illustrated) for holding the respective plurality of electrode units 14a.

The support unit 15 supports the electrode body 14, thereby supporting the holding body 13 and the contactors 12. Specifically, the support unit 15 has braces at four corners of the electrode body 14, and has a structure for supporting the electrode body 14.

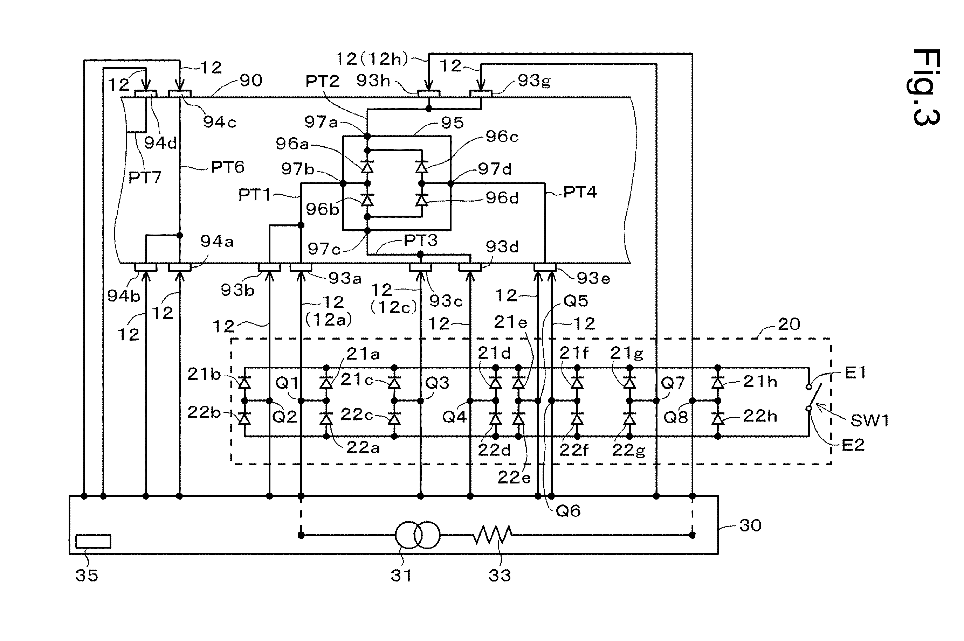

The wiring unit 16 is provided with wires extended from the electrode units 14a and electrically connects the electrode units 14a and a controller 30 of the circuit board inspection apparatus 1 (refer to FIG. 3). The wiring unit 16 is configured by using a wire rod (or a so-called conducing wire) such as insulating-coated copper (Cu).

The base unit 17 is configured as a base for the plurality of contactors 12, the holding body 13, the electrode 14, and the support unit 15. The base unit 17 has a function of fixing or holding the circuit board inspection tool 10 to the tool drive mechanism 2.

The switching circuit 20 will be described later.

### <3. Circuit Board>

In this embodiment, the circuit board with the built-in electronic component is exemplified as the circuit board 90 as the inspection object. The circuit board 90 is a circuit board in which an electronic component (or an integrated circuit (IC) herein) 95 is built (or a circuit board with a built-in electronic component (refer to FIG. 3).

In the electronic component 95, there are provided various electronic component elements (diodes, capacitors, resistors, etc.). In FIG. 3, however, only the diodes are illustrated for convenience of illustration. In FIG. 3, four diodes 96a to 96d are disposed in the electronic component 95. The diodes 96a to 96d inside the electronic component 95 are also referred to as internal didoes. The electronic component 95 is also provided with four IC terminals (referred to electronic component terminals) 97a to 97d.

On the surface of the circuit board 90 (specifically, the upper surface and the lower surface, etc.), there are provided a plurality of terminals 93 and 94. The plurality of terminals 93 and 94 are electrically connected to the wiring patterns inside the circuit board. In one portion, the plurality of terminals 93 or 94 are electrically connected to each other via the wiring pattern or the like inside the circuit board. In another portion, the plurality of terminals 93 or 94 are not electrically connected to each other inside the circuit board. Moreover, each of the plurality of terminals 93 is electrically connected to any of the plurality of IC terminals 97a to 97d of the electronic component 95 built in the circuit board (or inside the circuit board). On the other hand, each of the plurality of terminals 94 is not electrically connected to the electronic component 95 built in the circuit board.

For example, two terminals 93 (93a and 93b) are electrically connected to the IC terminal 97b inside the circuit board via a wiring pattern PT1. In the same manner, two terminals 93 (93g and 93h) are electrically connected to the IC terminal 97a inside the circuit board via a wiring pattern PT2. Two terminals 93 (93c and 93d) are electrically connected to the IC terminal 97c inside the circuit board via a wiring pattern PT3. One terminal 93 (93e) is electrically connected to the IC terminal 97d inside the circuit board via a wiring pattern PT4. The terminals 93a and 93b are electrically connected to each other, and the terminals 93c and 93d are electrically connected to each other. In the same manner, the terminals 93g and 93h are electrically connected to each other. On the other hand, each of the plurality of terminals 94 is not connected to any of the plurality of IC terminals 97a to 97d inside the circuit board of the electronic component 95 built in the circuit board.

Here, the terminals 93 and 94 on the circuit board 90 are used as the inspection points in the insulation inspection and the conduction inspection described later.

For example, in the conduction inspection between the terminals 93, the terminal (or electrode) 93a and the terminal (or electrode) 93b are used as the inspection points to confirm a conducting state (or a good conducting state) between the two terminals 93a and 93b. Moreover, the terminal 93a and the terminal 93h are used as the inspection points to confirm a conducting state (or a good conducting state) between the two terminals 93a and 93h. The same applies in the conduction inspection regarding the other terminals 93, and each of the terminals 93 is used as the inspection point in the conduction inspection.

Moreover, in the insulation inspection, at least one portion of the plurality of terminals 93 is used as the inspection point. For example, any terminal (e.g. 93a) of the two terminals 93a and 93b provided for the wiring pattern PT1 in the circuit board 90 and any terminal (e.g. 93h) of the two terminals 93g and 93h provided for the wiring pattern PT2 in the circuit board 90 are used as the inspection points to perform the insulation inspection between the two wiring patterns PT1 and PT2.

Moreover, in the insulation inspection, at least one portion of the plurality of terminals 94 is used as the inspection point. For example, any terminal (e.g. 94a) of three terminals 94a, 94b and 94c provided for a wiring pattern PT6 in the circuit board 90 and any terminal (e.g. 93h) of the two terminals 93g and 93h provided for the wiring pattern PT2 in the circuit board 90 are used as the inspection points to perform the insulation inspection between the two wiring patterns PT6 and PT2.

As described above, the terminals 93 and 94 are used as the inspection points in various inspections (including the conduction inspection and the insulation inspection).

### <4. Inspection Circuit>

FIG. 3 is a diagram illustrating an electronic circuit (or an inspection circuit) configured to inspect the circuit board 90.

As illustrated in FIG. 3, the circuit board inspection apparatus 1 is also provided with the controller 30. In FIG. 3, the illustration of the circuit board inspection tool 10 is omitted.

The controller 30 is a control unit configured to control various inspections. The controller 30 controls the output (or output current and/or output voltage) of a power supply 31 or the like, and performs the conduction inspection and the insulation inspection between the wiring patterns.

The power supply 31 is configured as a constant current source. The power supply 31 can adjust current supplied in the application of voltage, at a constant value.

In the conduction inspection, the power supply 31 supplies electric power such that a constant value of current flows while adjusting the applied voltage between the wiring patterns as the objects of the insulation inspection (or insulation-inspection-object wiring patterns) sequentially selected from the plurality of wiring patterns.

Moreover, in the insulation inspection, the power supply 31 applies various magnitudes of voltage (e.g. 0.2 V, 200 V, etc.) between the wiring patterns as the objects of the insulation inspection (or the wiring patterns as the insulation inspection objects) sequentially selected from the plurality of wiring patterns. FIG. 3 illustrates that one end of the power supply 31 is connected to the terminal 93a and the other end of the power supply 31 is connected to the terminal 93h. Actually, however, each of the both ends of the power supply 31 is sequentially connected to one or a plurality of terminals selected from among many terminals 93 and 94.

Moreover, a storage unit 35 of the controller 30 stores therein inspection pattern data in each inspection (e.g. the applied voltage in the insulation inspection, etc.) for each combination of the terminals as the inspection objects.

### <5. Conduction Inspection and Insulation Inspection>

Next, the conduction inspection and the insulation inspection will be explained. In the circuit board inspection apparatus 1, not only the conduction inspection and the insulation inspection regarding the terminals connected to the electronic component 95 but also the conduction inspection and the insulation inspection regarding the terminals not connected to the electronic component 95 can be also performed.

### <Conduction Inspection >

Firstly, the conduction inspection of the terminals 94 not connected to the electronic component 95 (refer to FIG. 3) will be explained.

For example, the terminal (or electrode) 94a and the terminal (or electrode) 94c are used as the inspection points to confirm a conducting state (or a good conducting state) between the two terminals 94a and 94c. More specifically, electric power is supplied such that a constant value of current flows while adjusting the applied voltage between the two terminals 94a and 94c. The conducting state can be confirmed from the flow of the current.

Next, the conduction inspection between the terminals 93 regarding the electronic component 95 (refer to FIG. 3) will be explained.

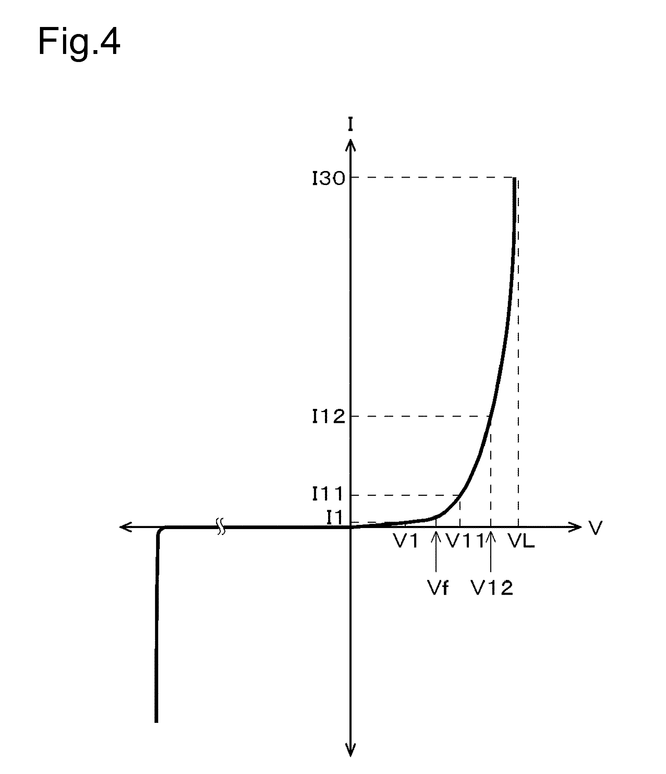

For example, the terminal 93a and the terminal 93h are used as the inspection points to confirm a conducting state (or a good conducting state) between the two terminals 93a and 93h. More specifically, electric power is supplied such that a constant value I11 (e.g. 1 milliampere (mA)) of current flows while adjusting the applied voltage between the two terminals 93a and 93h. The conducting state can be confirmed by confirming the flow of the current. The electrode component 95 includes the diodes. When the constant value I11 of current flows, a voltage V11 greater than a forward voltage Vf (e.g. 0.5 V) of the diodes is applied (refer to FIG. 4).

FIG. 4 is a diagram illustrating voltage-current characteristics of the diodes. As illustrated in FIG. 4, the current flows when the forward voltage is applied to the diodes. Specifically, if a voltage having a magnitude greater than the forward voltage Vf is applied in the forward direction of the diodes, the current flows in the diodes. However, the current hardly flows in the diodes even if a voltage with a magnitude less than the forward voltage Vf (e.g. 0.5 volts (V)) is applied in the forward direction of the diodes. This characteristic is used to perform the insulation inspection (which will be described later).

If the conducting state is confirmed by the conduction inspection between the two terminals 93a and 93h as described above, it is possible to confirm that the wiring pattern PT1 connected to the terminal 93a and the wiring pattern PT 2 connected to the terminal 93h are electrically connected via the diode 96a.

### <Insulation Inspection>

Next, the insulation inspection between the terminals 93 connected to the electronic component 95 will be explained.

For example, the terminal 93a provided for the wiring pattern PT1 in the circuit board 90 and the terminal 93h provided for the wiring pattern PT2 in the circuit board 90 are used as the inspection points to perform the insulation inspection between the two wiring patterns PT1 and PT2. More specifically, it is possible to confirm that the two wiring patterns PT1 and PT2 are insulated in a portion other than a connecting portion by the diode 96a.

The insulation inspection uses the characteristic that "the current hardly flows in the diodes even if a voltage with a magnitude less than the forward voltage Vf (e.g. 0.5 volts (V)) is applied in the forward direction of the diodes". More specifically, a voltage V1 (e.g. 0.2 volts (V)) less than the forward voltage Vf is applied between the terminal 93a provided for the wiring pattern PT1 and the terminal 93h provided for the wiring pattern PT2. If a current value measured at this time is less than a predetermined threshold value TH1 (e.g. 0.2 mA), it is clear (or determinable) that the two wiring patterns PT1 and PT2 are insulated in the portion other than the connecting portion by the diode 96a. On the other hand, if a current value greater than the threshold value TH1 flows, it is clear (or determinable) that there is an insulation failure between the two wiring patterns PT1 and PT2.

Next, the insulation inspection between the terminals 94 not connected to the electronic component 95 will be explained. Specifically, voltage is applied between the two terminals 94 to confirm an insulating state between the two wiring patterns corresponding to the two terminals.

For example, the terminal 94a provided for the wiring pattern PT6 in the circuit board 90 and a terminal 94d provided for a wiring pattern PT7 are used as the inspection points to perform the insulation inspection between the two wiring patterns PT6 and PT7.

Here, since the terminals 94 are not connected to the electronic component 95, relatively high voltage (e.g. 250 volts (V)) is preferably applied to confirm a more certain insulating state.

Moreover, the insulation inspection is performed on the terminal 94 not connected to the electronic component 95 and the terminal 93 connected to the electronic component 95. Specifically, voltage is applied between the terminal 94 and the terminal 93 to confirm an insulating state between the wiring pattern regarding the terminal 94 not connected to the electronic component 95 and the wiring pattern regarding the terminal 93 connected to the electronic component 95. For example, the terminal 94a provided for the wiring pattern PT6 in the circuit board 90 and the terminal 93h provided for the wiring pattern PT2 in the circuit board 90 are used as the inspection points to perform the insulation inspection between the two wiring patterns PT6 and PT2. Even in the insulation inspection, relatively high voltage (e.g. 250 V) may be applied in some cases.

Here, as described above, if the inspection condition stored in the circuit board inspection apparatus is wrong, high voltage is incorrectly applied between the terminals 93 connected to the electronic component 95, and the electronic component built in the circuit board as the inspection object (or the circuit board with the built-in electronic component) is damaged. For example, if a high voltage of 250 volts (V) is incorrectly applied between the terminal 93a and the terminal 93h, the electronic component (IC) 95 in the circuit board 90 is damaged.

Now, an explanation will be given to a technology of avoiding the damage of the electronic component 95 by using diodes 21 and 22 of the switching circuit 20, or the like, in the embodiment.

### <6. Switching Circuit>

As illustrated in FIG. 3, the switching circuit 20 is disposed between each of the contactors 12 and the controller 30 (or the power supply 31 or the like) outside the circuit board 90, and is provided with a plurality of diodes, a single switch SW1, and wires for connecting the diodes and the switch.

The switching circuit 20 is configured by using a wire branched from a branch portion (or also referred to as a wire connecting unit) Q disposed in the middle of the wiring unit 16 connected to each of the contactors 12. Specifically, the two diodes 21 and 22 are provided for the wire connecting unit Q of each contactor 12. More specifically, an anode (or a positive electrode) of one diode 21 is connected (or specifically, electrically connected) to the wire connecting unit Q, and a cathode (or a negative electrode) of the one diode 21 is connected to one end E1 side of the switch SW1. Moreover, a cathode (or a negative electrode) of the other diode 22 is connected to the wire connecting unit Q, and an anode (or a positive electrode) of the other diode 22 is connected to the other end E2 side of the switch SW1.

For example, two diodes 21a and 22a are provided for a wire connecting unit Q1 of the contactor 12 corresponding to the terminal 93a. Specifically, the anode (or the positive electrode) of the diode 21a is connected to the wire connecting unit Q1, and the cathode (or the negative electrode) of the diode 21a is connected to the one end E1 side of the switch SW1. Moreover, the cathode (or the negative electrode) of the other diode 22a is connected to the wire connecting unit Q1, and the anode (or the positive electrode) of the other diode 22a is connected to the other end E2 side of the switch SW1.

In the same manner, two diodes 21h and 22h are provided for a wire connecting unit Q8 of the contactor 12 corresponding to the terminal 93h. Specifically, the anode (or the positive electrode) of the diode 21h is connected to the wire connecting unit Q8, and the cathode (or the negative electrode) of the diode 21h is connected to the one end E1 side of the switch SW1. Moreover, the cathode (or the negative electrode) of the other diode 22h is connected to the wire connecting unit Q8, and the anode (or the positive electrode) of the other diode 22h is connected to the other end E2 side of the switch SW1.

For each of wire connecting units Q2 to Q7 of the contactors 12 corresponding to the other terminals 93b to 93g, two diodes ((21b and 22b) to (21g and 22g)) are provided.

The switch SW1 switches between ON and OFF, thereby simultaneously switching between a state ST1 and a state ST0 (which described in the next paragraph) with respect to a plurality of pairs of contactors (12a, 12h), (12c, 12h), and so on. Incidentally, the contactors 12a, 12c and 12h are the contactors 12 which are in contact with the corresponding terminals 93a, 93c and 93h, respectively.

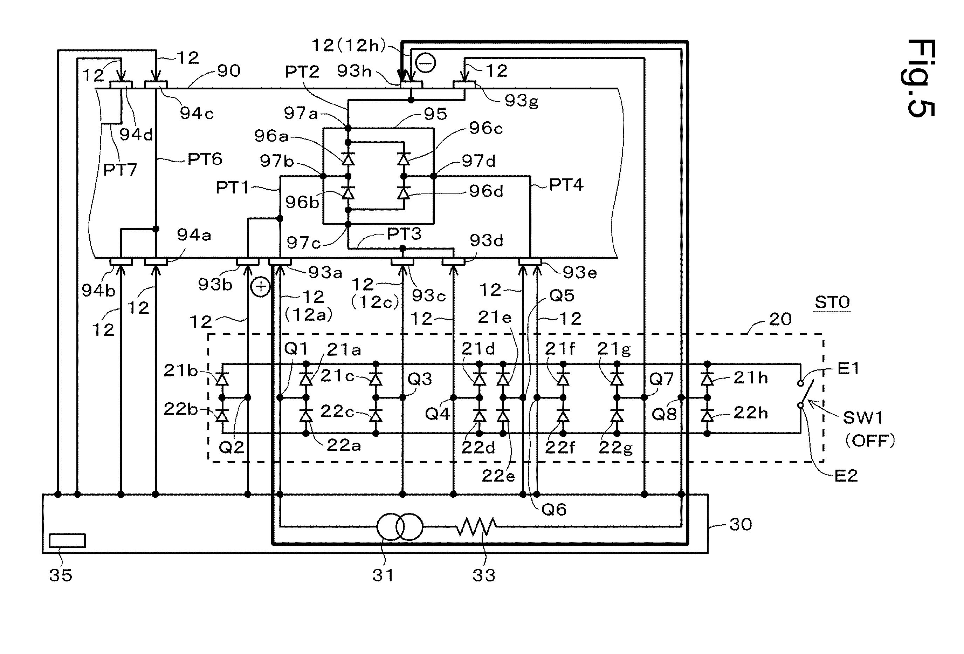

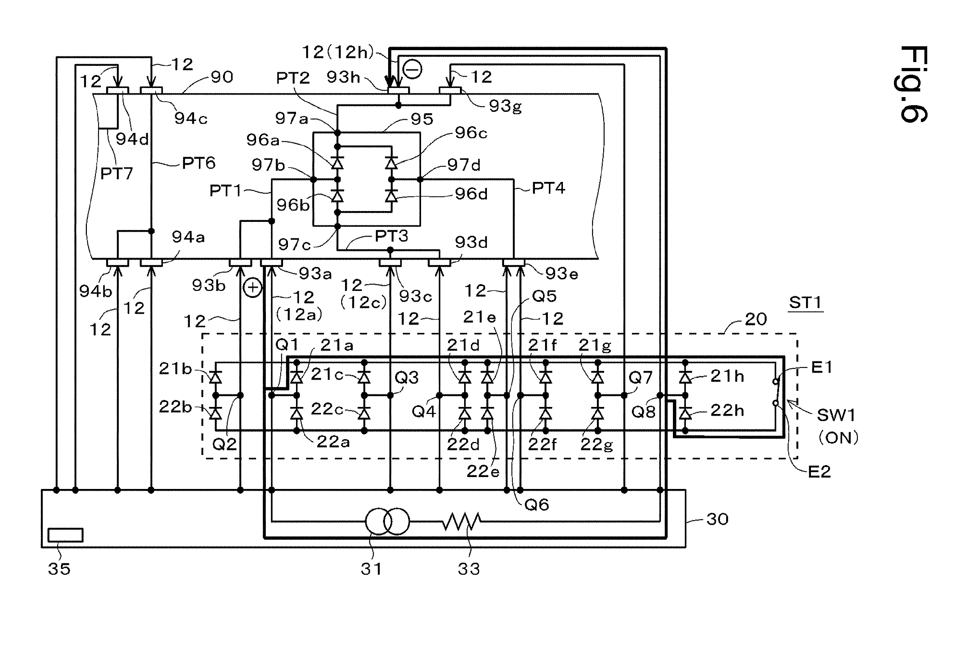

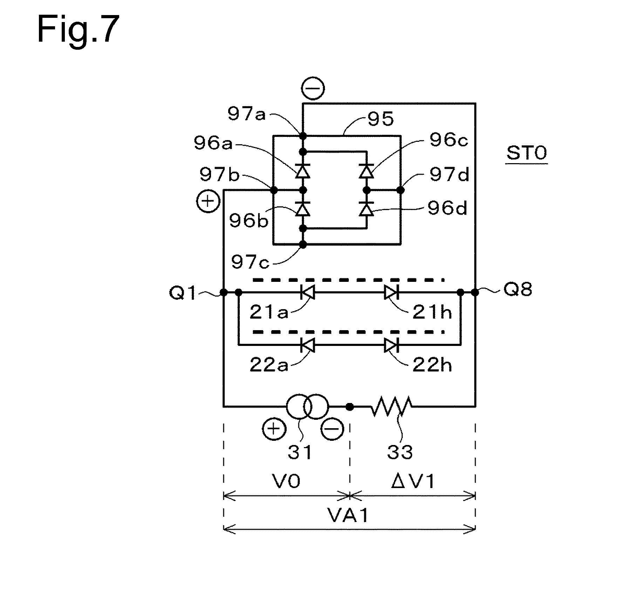

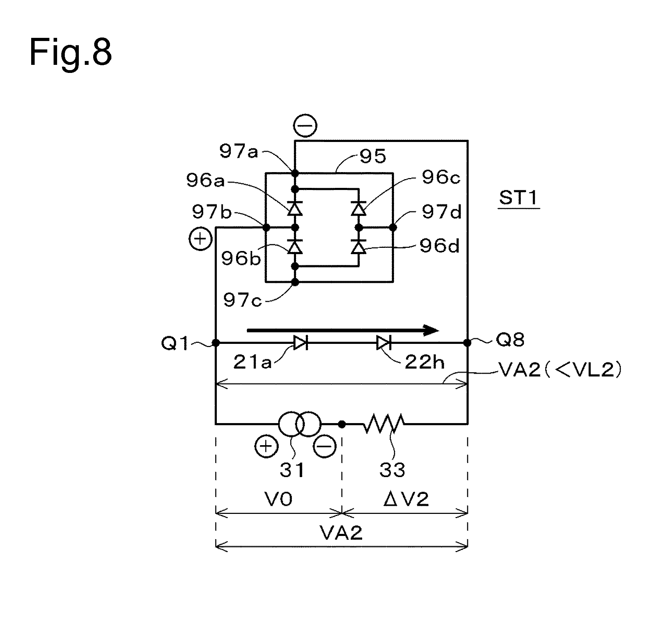

FIG. 5 is a diagram illustrating the inspection circuit in which the switch SW1 is OFF, and FIG. 6 is a diagram illustrating the inspection circuit in which the switch SW1 is ON. FIG. 7 is a diagram illustrating an equivalent circuit obtained by extracting one portion of FIG. 5. FIG. 8 is a diagram illustrating an equivalent circuit obtained by extracting one portion of FIG. 6. By switching between ON and OFF of the switch SW1 of the switching circuit 20, a situation in FIG. 5 (or FIG. 7) (or the state ST0) and a situation in FIG. 6 (or FIG. 8) (or the state ST1) are selectively realized. Hereinafter, a situation in which one end of the power supply 31 is connected to the terminal 93a and the other end of the power supply 31 is connected to the terminal 93h will be mainly explained.

If the switch SW1 is OFF (or expressed as, if the switching circuit 20 has the state ST0), the switching circuit 20 does not practically operate. In other words, the situation in which the switching circuit 20 is provided is equivalent to a situation in which the switching circuit 20 is not provided. Specifically, as in illustrated in FIG. 5 and FIG. 7, two pairs of diodes (21a, 21h) and (22a, 22h) are connected in parallel between the wire connecting unit Q1 and the wire connecting unit Q8. Specifically, between the wire connecting unit Q1 and the wire connecting unit Q8, there are a pathway in which the diodes 21a and 21h are connected in series and a pathway in which the diodes 22a and 22h are connected in series. In each of the pathways which connect the wire connecting unit Q1 and the wire connecting unit Q8, the diodes 21a and 21h are arranged opposite to each other, and the diodes 22a and 22h are also arranged opposite to each other. Therefore, no current flows between the wire connecting unit Q1 and the wire connecting unit Q8.

As described later, the switch SW1 is set to be OFF in the conduction inspection. Moreover, the switch SW1 is set to be ON in the insulation inspection.

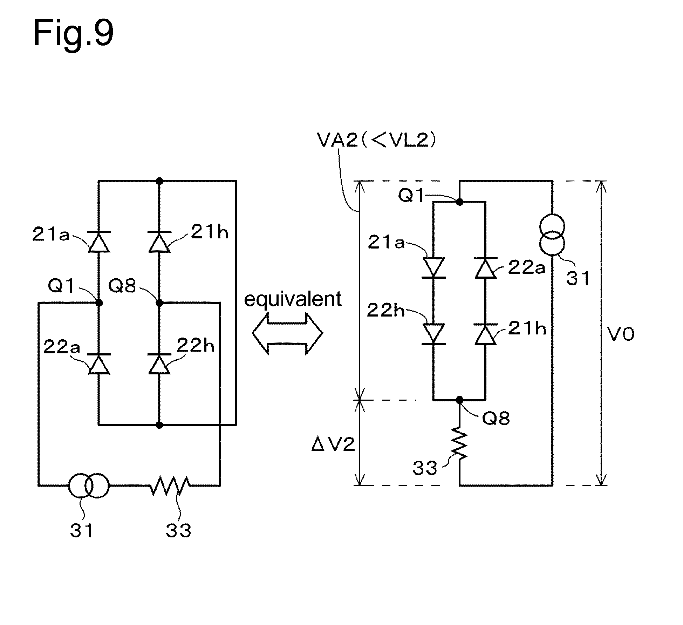

On the other hand, if the switch SW1 is ON (or expressed as, if the switching circuit 20 has the state ST1), the switching circuit 20 operates in the same manner as in the equivalent circuit illustrated in FIG. 8 and FIG. 9. As in illustrated in FIG. 6, FIG. 8 and FIG. 9, between the wire connecting unit Q1 and the wire connecting unit Q8, there are a pathway in which the diodes 21a and 22h are connected in series (in the same direction with each other) and a pathway to which the diodes 22a and 21h are connected in series (in the same direction with each other), (in addition to the pathway in which the diodes 21a and 21h are connected in series and the pathway in which the diodes 22a and 22h are connected in series).

Out of the pathways, none of the pathway in which the diodes 21a and 21h are connected in series opposite to each other and the pathway in which the diodes 22a and 22h are connected in series opposite to each other is supplied with current.

In contrast, current can flow in one of both the pathways (refer to FIG. 9) which are the pathway in which the diodes 21a and 22h are connected in series in the same direction with each other and the pathway in which the diodes 22a and 21h are connected in series in the same direction with each other, depending on a magnitude correlation between the potential of the wire connecting unit Q1 and the potential of the wire connecting unit Q8.

For example, as illustrated in FIG. 6, when the potential of the wire connecting unit Q1 is higher (or greater) than the potential of the wire connecting unit Q8, forward voltage (or forward bias) is applied to the diodes 21a and 22h inserted between a contactor 12a and a contactor 12h outside the circuit board 90. In particular, if a relatively high voltage Vh (e.g. several volts to several hundred volts) is applied to the diodes 21a and 22h, current (or forward current) flows in the pathway in which the diodes 21a and 22h are connected in series in the same direction with each other (also referred to as an alternate pathway or a diversion circuit or a detour circuit). At this time, a potential difference between the wire connecting unit Q1 and the wire connecting unit Q8, i.e. a potential difference between the terminal 93a and the terminal 93h, is equal to a potential difference VA2 between the ends of the diodes 21a and 22h (refer to FIG. 8). Incidentally, since reverse voltage is applied to both the diodes 22a and 21h connected in series in the same direction with each other, no current flows in the diodes 22a and 21h.

Here, as illustrated in FIG. 6, when the potential of the wire connecting unit Q1 is higher (or greater) than the potential of the wire connecting unit Q8 to a predetermined extent or more, current flows in the pathway in which the diodes 21a and 22h are connected in series in the same direction with each other. At this time, the voltage VA2 between the ends of the two diodes 21a and 22h (or voltage between the anode of the diode 21a and the cathode of the diode 22h) (refer to FIG. 8) remains at a relatively small value VL (e.g. 1.5 volts (V)).

This will be explained with reference to FIG. 4.

As illustrated in the characteristic curve of the diodes in FIG. 4, current I increases with increasing forward voltage V (in other words, voltage V increases with increasing current I); however, in comparison with the increase in the current I, the increase in the voltage V is relatively suppressed.

For example, when the voltage V1 (<the forward voltage Vf) is applied, only a small current I1 flows. Then, when the voltage V11 greater than the forward voltage Vf is applied, the current I11 flows. Then, when a larger voltage V12 is applied, a current I12 flows. In other words, as the current increases from the current I11 to the current I12, the voltage V between the ends of the diodes also increases from the voltage V11 to the voltage V12. Then, the voltage V also increases with increasing current I; however, in comparison with the increase in the current I, the increase in the voltage V is relatively suppressed, and the voltage V between the ends of the diodes increases mostly up to the limit value VL.

If the limit value VL of the forward voltage of a single diode is about 1.5 volts (V), the voltage VA2 between the ends of the two diodes 21 and 22 remains at a limit value VL2 (about 3.0 volts (V)). Theoretically, if the current I which flows in the diodes increases infinitely, the voltage V between the ends of the diodes also extremely increases. Actually, however, there is a limit for a current value which can be outputted by the power supply 31, and there is the limit value VL2 according to the limit.

Now, in the situation illustrated in FIG. 9 and FIG. 8, it is assumed that the power supply 31 incorrectly applies relatively high voltage (e.g. 20 volts (V)). If the switch SW1 of the switching circuit 20 is ON and the state ST1 is selected (refer to FIG. 6), and if voltage is applied between the terminal 93a and the terminal 93h such that the terminal 93a side is high potential, then, the forward bias is applied between the diodes 21a and 22h inserted between the wire connecting unit Q1 and the wire connecting unit Q8. In particular, if the relatively high voltage Vh is applied to the diodes 21a and 22h, the current (or forward current) flows in the diodes 21a and 22h. At this time, the voltage VA2 between the ends of the two diodes 21a and 22h (or the voltage between the anode of the diode 21a and the cathode of the diode 22h) (refer to FIG. 8) remains at the relatively small value VL2 (e.g. 3 volts (V)). Specifically, as described above, if the limit value (or maximum value) VL of the forward voltage of a single diode is about 1.5 volts (V), the voltage VA2 between the ends of the two diodes remains at the limit value (or maximum value) VL2 (about 3.0 volts (V)). At this time, a voltage ΔV2 (=V0-VL2) (e.g. 17 volts (V)) is applied to an internal resistor 33 of the circuit board inspection apparatus 1, or the like.

Moreover, the potential difference between the terminal 93a and the terminal 93h remains at the relatively small value VL2 because the potential difference is equal to the potential difference VA2 between the ends of the diodes 21a and 22h. In other words, the voltage between the terminal 93a and the terminal 93h (=VA2) can be limited to the value VL2.

If the voltage VL2 is less than or equal to withstand voltage of the electronic component 95 (e.g. 10 volts (V)), the damage of the electronic component 95 can be avoided well.

If current flows beyond a threshold value TH5 (e.g. 0.5 A), the voltage application is preferably controlled to be stopped instantly. Even if extremely large current flows, the circuit board inspection apparatus 1 is damaged, and the voltage application is ended. According to this, at least, it is possible to prevent the damage of the electronic component 95.

As described above, even if the power supply 31 incorrectly applies relatively high voltage, the forward current flows in the diodes 21a and 22h inserted between the wire connecting unit Q1 and the wire connecting unit Q8, and the potential difference between the terminal 93a and the terminal 93h is limited to the limit value VL2 of the potential difference VA2 between the ends of the diodes 21a and 22h. This makes it possible to prevent the damage of the electronic component 95.

In the above, the case where the potential of the wire connecting unit Q1 is higher (or greater) than the potential of the wire connecting unit Q8 was mainly explained. Even if the potential of the wire connecting unit Q1 is lower (or less) than the potential of the wire connecting unit Q8, the damage of the electronic component 95 can be prevented in the same manner.

Specifically, unlike FIG. 6, if the potential of the wire connecting unit Q1 is lower (or less) than the potential of the wire connecting unit Q8, forward voltage is applied to the diodes 22a and 21h. In particular, if the relatively high voltage Vh is applied to the diodes 22a and 21h, current flows in the pathway in which the diodes 22a and 21h are connected in series in the same direction with each other (refer to FIG. 9). At this time, the potential difference between the wire connecting unit Q1 and the wire connecting unit Q8 (or the potential difference between the terminal 93a and the terminal 93h) is equal to the potential difference VA2 between the ends of the diodes 22a and 21h. Incidentally, since reverse voltage is applied to both the diodes 21a and 22h connected in series in the same direction with each other, no current flows in the diodes 21a and 22h.

Therefore, even if the relatively high voltage Vh is incorrectly outputted by the power supply 31, the potential difference between the terminal 93a and the terminal 93h is equal to the potential difference VA2 between the ends of the diodes 22a and 21h, and remains at the relatively small value VL2 (e.g. 3 volts (V)). In other words, the voltage between the terminal 93a and the terminal 93h can be limited to the value VL2, and the damage of the electronic component 95 due to the high voltage application can be avoided. In particular, even if relatively high voltage with reversed polarity is incorrectly applied, the damage of the electronic component 95 can be avoided.

When the applied voltage by the power supply 31 is the relatively small value (or normal value) V1 (e.g. 0.2 volts (V)), the forward current does not flow in the diodes 21 and 22 even if the forward bias is applied to the ends of the diodes 21 and 22. Therefore, the insulation inspection can be normally performed between the patterns PT1 and PT2. Specifically, if no current flows between the contactor 12a and the contactor 12h even if the normal voltage V1 is applied by the power supply 31, it is determined that the patterns PT1 and PT2 are insulated well. On the other hand, a current greater than or equal to the threshold value TH1 flows between the contactor 12a and the contactor 12h according to the voltage application by the power supply 31, it is determined that there is an insulation failure between the patterns PT1 and PT2.

### <7. Inspection Operation>

At the time of the inspection of the circuit board 90 by the circuit board inspection apparatus 1, the inspection is performed in the state in which the plurality of contactors (or probes) provided for the circuit board inspection tools 10a and 10b described above are in contact with the corresponding terminals (93, 94) (refer to FIG. 3). In a period of the various inspections regarding the mutual relation between the plurality of terminals in the circuit board 90, the contact state is not released but is maintained. On the other hand, according to the inspection pattern data stored in the controller 30, two or more terminals as the inspection objects are selected from among the many terminals, and the respective contactors corresponding to the selected two or more terminals are specified. Then, the voltage or the like to be applied to each of the specified contactors is determined according to the inspection pattern data, and the inspection regarding the selected terminals is performed. By repeating the operation, a plurality of inspections regarding the circuit board 90 is performed.

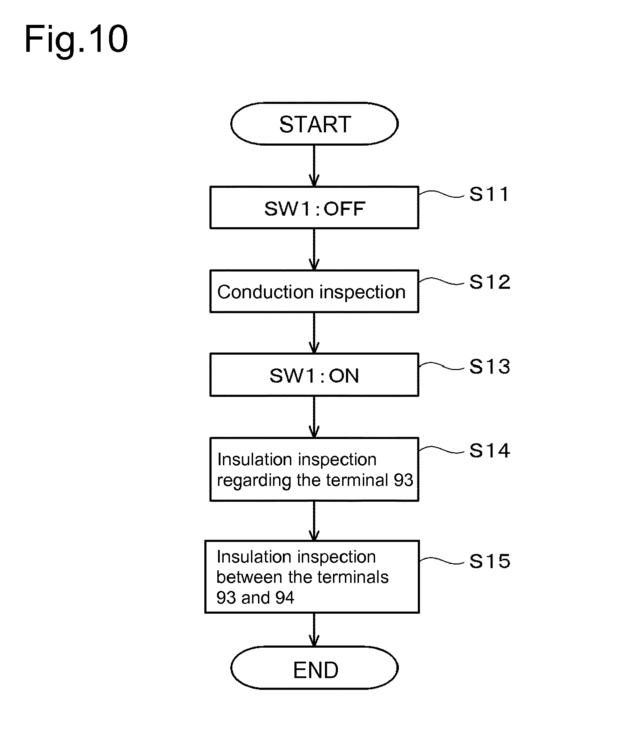

FIG. 10 is a flowchart illustrating an inspection procedure as described above.

Hereinafter, with reference to FIG. 10 and the like, an explanation will be given to an aspect in which the following three inspections are performed in this order; namely,
(1) Conduction inspection regarding the terminals 93 (step S12),
(2) Insulation inspection regarding the terminals 93 (step S14), and
(3) Insulation inspection regarding the terminals 93 and 94 (step S15).

(1) Firstly, after the switch SW1 of the switching circuit 20 is set to be OFF (step S11), the "conduction inspection" for inspecting the conducting state (or the good conducting state) between the plurality of terminals 93 is performed (step S12).

More specifically, the conduction inspection is performed in the state ST0 illustrated in FIG. 5 (and FIG. 7).

For example, as described above, the conduction inspection is performed between the two terminals 93a and 93h. As a result, the conducting state can be confirmed from the conduction inspection between the two terminals 93a and 93h. Specifically, it can be confirmed that the wiring pattern PT1 connected to the terminal 93a and the wiring pattern PT2 connected to the terminal 93h are electrically connected via the diode 96a.

Moreover, the conduction inspection is performed between the two terminals 93c and 93h. By this, it can be confirmed that the wiring pattern PT3 connected to the terminal 93c and the wiring pattern PT2 connected to the terminal 93h are electrically connected to the diodes 96a and 96b.

Moreover, the conduction inspection is performed between the two terminals 93e and 93h. By this, it can be confirmed that the wiring pattern PT4 connected to the terminal 93e and the wiring pattern PT2 connected to the terminal 93h are electrically connected to the diode 96c.

In the same manner, the conduction inspection between the terminals 93 regarding another combination is performed, such as the conduction inspection between the two terminals 93c and 93a.
(2) Then, the "insulation inspection" for inspecting a non-conducting state (or a good insulating state) between the two terminals 93 is performed (step S14). The insulation inspection is performed after the switch SW1 of the switching circuit 20 is changed to be ON (step S13).

More specifically, the insulation inspection is performed in the state ST1 illustrated in FIG. 6 (and FIG. 8).

For example, as described above, the insulation inspection between the two terminals 93a and 93h is performed. As a result, the quality of the insulating state is confirmed from the insulation inspection between the two terminals 93a and 93h. Specifically, it is confirmed that the wiring pattern PT1 connected to the terminal 93a and the wiring pattern PT2 connected to the terminal 93h are insulated well in the portion other than the connecting portion by the diode 96a. Alternatively, it is confirmed that there is an insulation failure between the wiring patterns PT1 and PT2.

Moreover, the insulation inspection is performed between the two terminals 93c and 93h. By this, it is confirmed that the wiring pattern PT3 connected to the terminal 93c and the wiring pattern PT2 connected to the terminal 93h are insulated in a portion other than a connecting portion the diodes 96a and 96b. Alternatively, it is confirmed that there is an insulation failure between the wiring patterns PT3 and PT2.

Moreover, the insulation inspection is performed between the two terminals 93e and 93h. By this, it is confirmed that the wiring pattern PT4 connected to the terminal 93e and the wiring pattern PT2 connected to the terminal 93h are insulated in a portion other than a connecting portion the diode 96c. Alternatively, it is confirmed that there is an insulation failure between the wiring patterns PT4 and PT2.

In the same manner, the insulation inspection between the terminals 93 regarding another combination is performed, such as the insulation inspection between the two terminals 93c and 93a.
(3) Then, the insulation inspection for inspecting a non-conducting state (or a good insulating state) between the terminal 94 not connected to the electronic component 95 and the terminal 93 connected to the electronic component 95 is performed (step S15). This insulation inspection is also performed while the switch SW1 of the switching circuit 20 is set to be ON.

For example, as described above, the insulation inspection is performed between the two terminals 94a and 93h. As a result, the quality of the insulating state is confirmed from the insulation inspection between the two terminals 94a and 93h. Specifically, it is confirmed that the wiring pattern PT6 connected to the terminal 94a and the wiring pattern PT2 connected to the terminal 93h are insulated well. Alternatively, it is confirmed that there is an insulation failure between the wiring patterns PT6 and PT2.

As described above, the various inspections are performed in the circuit board inspection apparatus 1. Incidentally, the inspection regarding the terminals related to the electronic component 95 was mainly explained, but the inspection regarding the terminals not related to the electronic component 95 may be also performed together. For example, the conduction inspection between the plurality of terminals 94 not connected to the electronic component 95 may be also performed between the step S12 and the step S13. Moreover, the insulation inspection between the plurality of terminals 94 not connected to the electronic component 95 may be also performed after the step S15.

According to the operation as described above, it is possible to prevent the damage of the electronic component 95 built in the circuit board 90 as the inspection object by performing the insulation inspection in the step S 14 while the switch SW1 of the switching circuit 20 is set to be ON.

Specifically, for example, in the inspection of the insulating state between the terminal 93a and the terminal 93h, voltage is applied therebetween in the state in which the forward bias is applied to the diodes 21a and 22h inserted between the contactor 12a which is in contact with the terminal 93a and the contactor 12h which is in contact with the terminal 93h. At this time, the potential difference between the contactors 12a and 12h (in other words, the potential difference between the terminal 93a and the terminal 93h) is equal to the potential difference VA2 between the ends of the diodes 21a and 22h. Moreover, the potential difference VA2 between the ends of the diodes 21a and 22h in which the forward current flows is limited to the relatively small voltage VL2. Thus, even if the power supply 31 incorrectly outputs relatively high voltage (e.g. 250 volts (V)), the potential difference between the terminal 93a and the terminal 93h is limited to the maximum value (e.g. 3 volts (V)) of the potential difference VA2 between the ends of the diodes 21a and 22h. It is therefore possible to prevent the electronic component 95 built in the circuit board, which is connected to the terminals 93a and 93h, from being damaged by the incorrect voltage application in the insulation inspection.

More specifically, the switching circuit 20 disposed between the plurality of contactors 12 including the contactor 12a and the contactor 12h switches between the two states ST1 and STO. Specifically, the switching circuit switches between the state ST1 in which the forward current flows in the diodes each of which is disposed between respective one of a plurality of contactor pairs regarding the plurality of contactors 12 to form a diversion circuit between the respective one of the plurality of contactor pairs (refer to FIG. 6), and the state ST0 in which the diversion circuit is blocked between the respective one of the plurality of contactor pairs (refer to FIG. 5).

In the state ST0, for example, the two diodes 21a and 21h are electrically connected opposite to each other between the contactors 12a and 12h, and no current flows in the two diodes 21a and 21h. Moreover, the two diodes 22a and 22h are also electrically connected opposite to each other between the contactors 12a and 12h, and no current flows in the two diodes 22a and 22h. Therefore, a diversion circuit between the contactors 12a and 12h is blocked. In the state ST0 as described above, the conduction inspection (the step S12) is preferably performed.

In the state ST1, for example, the forward current flows in the diodes 21a and 22h inserted between the contactor pair (12a, 12h) outside the circuit board 90 to form a diversion circuit between the contactors 12a and 12h. Specifically, the two diodes 21a and 22h are electrically connected in the same direction between the contactors 12a and 12h, and the current flows in the two diodes 21a and 22h to form the diversion circuit. The same applies to the other contactor pairs. In the state ST1, the forward current flows in the diodes each of which is disposed between the respective one of the plurality of contactor pairs regarding the plurality of contactors 12, by which the diversion circuit can be formed between the respective one of the plurality of contactor pairs.

By performing the insulation inspection as described above in the state ST1, it is possible to prevent the electronic component 95 built in the circuit board, which is connected to the terminals 93a and 93h, from being damaged by the incorrect voltage application. As described above, both the conduction inspection and the insulation inspection can be performed well by selectively realizing the two states ST0 and ST1 by using the switching circuit 20.

In the switching circuit 20, a situation in which the diversion circuit using the diodes can be formed (or a situation in which the forward bias can be applied to the diodes) occurs with regard to the plurality of terminal pairs (93, 93) connected to the electronic component 95. Specifically, in the state ST1, the forward current flows in the diodes each of which is disposed between the respective one of the plurality of contactor pairs regarding the plurality of contactors 12, and the diversion circuit can be formed between the respective one of the plurality of contactor pairs. It is therefore possible to prevent the damage of the electronic component 95 built in the circuit board even if incorrect voltage is applied to the terminal pairs regarding another combination other than the terminal pair (93a, 93h). For example, even if relatively high voltage is incorrectly applied to the terminal pair (93c, 93h) different from the original terminal pair (93a, 93h), the damage of the electronic component 95 can be avoided. Moreover, it is also possible to avoid the damage of the electronic component 95 while sequentially performing the insulation inspection regarding the plurality of terminal pairs, without changing the state of the switch SW1.

Moreover, in the switching circuit 20, the single switch SW1 switches between the two states ST1 and ST0 regarding the plurality of contactor pairs, and the switching circuit 20 can be thus simply configured.

In particular, for example, in the insulation inspection between the terminal 93a and the terminal 93h, the diodes 21a and 22h are inserted in a predetermined direction DR1 and the diodes 22a and 21h are inserted in an opposite direction DR2, between the contactor 12a which is in contact with the terminal 93a and the contactor 12h which is in contact with the terminal 93h (outside the circuit board 90) (refer to FIG. 6 and FIG. 9). The diodes 21a and 22h and the diodes 22a and 21h are inserted in parallel between the contactors. Here, the direction DR1 is a direction in which the anode (or the positive electrode) of the diode is disposed on the wire connecting unit Q1 side, and the direction DR2 is a direction in which the cathode (or the negative electrode) of the diode is disposed on the wire connecting unit Q1 side.

If the wire connecting unit Q1 has a higher potential than that of the wire connecting unit Q8 to a predetermined extent or more, current flows in the diodes 21a and 22h disposed in the predetermined direction DR1 between the contactors 12a and 12h, and the potential difference between the contactors 12a and 12h (in other words, the potential difference between the terminal 93a and the terminal 93h) is limited to the maximum value VL2 of the potential difference VA2 between the ends of the diodes 21a and 22h. It is therefore possible to prevent the electronic component 95 built in the circuit board, which is connected to the terminals 93a and 93h, from being damaged by the incorrect voltage application in the insulation inspection.

On the other hand, if the wire connecting unit Q8 has a higher potential than that of the wire connecting unit Q1 to a predetermined extent or more, current flows in the diodes 21h and 22a disposed in the opposite direction DR2 between the contactors 12a and 12h, and the potential difference between the contactors 12a and 12h (in other words, the potential difference between the terminal 93a and the terminal 93h) is limited to the maximum value VL2 of the potential difference VA2 between the ends of the diodes 21h and 22a. It is therefore possible to prevent the electronic component 95 built in the circuit board, which is connected to the terminals 93a and 93h, from being damaged by the incorrect voltage application in the insulation inspection.

As described above, in the situation in which the switching circuit 20 is set to be ON, current flows in one pair (or specifically, one diode pair) of the diodes 21a and 22h and the diodes 21h and 22a even if the relatively high voltage Vh is incorrectly applied in any direction. At this time, the potential difference VL2 between the ends of the one pair of the diodes (e.g. the diode pair (21a, 22h)) is equal to the potential difference VA2 between the contactors 12a and 12h (in other words, the potential difference between the terminal 93a and the terminal 93h). It is therefore possible to prevent the electronic component 95 built in the circuit board, which is connected to the terminals 93a and 93h, from being damaged by the incorrect voltage application, regardless of the direction of the incorrect voltage.

In the step S15, the insulation inspection is performed between the terminal 93 connected to the electronic component 95 and the terminal 94 not connected to the electronic component 95. In this insulation inspection (the step S15), the situation in which the incorrect voltage is applied between the terminal 93a and the terminal 93h while the contactor 12a is in contact with the terminal 93a and the contactor 12h is in contact with the terminal 93h can be considered. In the embodiment, the ON state of the switch SW1 (or the state ST1) is continued in this situation. As a result, even when the insulation inspection is performed between the terminal 93h and the terminal 94a, for example, the state in which the potential difference between the contactor 12a and the contactor 12h is equal to the potential difference VA2 between the ends of the two diodes 21a and 22h is continued. Therefore, if the insulation inspection is performed between the terminal 93 connected to the electronic component 95 and the terminal 94 not connected to the electronic component 95 and even when the high voltage Vh is incorrectly applied between the terminal 93a and the terminal 93h, it is possible to prevent the electronic component 95 built in the circuit board, which is connected to the terminal 93a and 93h, from being damaged by the incorrect voltage application. The same applies to the other terminal pairs (93, 93).

As described above, the ON state of the switch SW1 (or the state ST1) is continued when the insulation inspection is performed between the terminal 93 connected to the electronic component 95 and the terminal 94 not connected to the electronic component 95. This makes it possible to prevent the damage of the electronic component 95 even if the relatively high voltage Vh is incorrectly applied to the terminals 93 connected to the electronic component 95.

### <8. Modified Example, etc.>

In the above, the embodiment of the present invention was explained; however, the present invention is not limited to the content explained above.

For example, in the embodiment, the single switch SW1 is used in the switching circuit 20 to simultaneously switch between the two states ST1 and ST0 regarding the plurality of contactor pairs. It is, however, not limited to this example, and a plurality of switches may be used to switch between the two states ST1 and ST0 for the respective terminal pairs.

Moreover, the embodiment exemplifies the aspect in which the two diodes 21a an d22h are inserted between the terminal 93a and the terminal 93h in the insulation inspection between the terminal 93a and the terminal 93h; however, it is not limited to this example. For example, only one diode (e.g. only the diode 21a) may be inserted between the terminal 93a and the terminal 93h.

Moreover, the embodiment is configured to respond to the incorrect voltage application in two directions by having the configuration as illustrated in FIG. 9 in the state ST1; however, it is not limited to this example. For example, there may be provided the switching circuit 20 improved to respond only to the incorrect voltage application in a particular direction.

Moreover, in the embodiment, the processing in the steps S11 and S12 is performed before the processing in the step S13; however, it is not limited to this example. For example, the processing in the steps S11 and S12 may be performed after the processing in the step S15.

### < Description of Reference Numerals

- 1: circuit board inspection apparatus
- 2: tool drive mechanism
- 3: conveying table
- 10: circuit board inspection tool
- 12: contactor
- 13: holding body
- 14: electrode body
- 15: support unit
- 16: wiring unit
- 17: base unit
- 20: switching circuit
- 21,22: diode
- 30: controller
- 31: power supply
- 33: internal resistor
- PT: wiring pattern
- Q: wire connecting unit

## Claims

1. A circuit board inspection apparatus configured to perform electrical inspection of wiring patterns formed on a circuit board with a built-in electronic component, said circuit board inspection apparatus comprising:
a first contactor configured to be brought into contact with a first inspection point on the circuit board, the first inspection point being electrically connected to a first terminal of the electronic component;
a second contactor configured to be brought into contact with a second inspection point on the circuit board, the second inspection point being electrically connected to a second terminal of the electronic component; and
a controlling device configured to apply voltage between the first contactor and the second contactor by using a power supply and to inspect an insulating state between a first wiring pattern electrically connected to the first inspection point and a second wiring pattern electrically connected to the second inspection point, wherein
the controlling device applies the voltage between the first contactor and the second contactor in a state in which forward bias is applied to a diode inserted between the first contactor and the second contactor outside the circuit board, and inspects the insulating state between the first wiring pattern and the second wiring pattern in such a manner that a potential difference between the first contactor and the second contactor is equal to a potential difference between ends of the diode when forward current flows in the diode.

2. The circuit board inspection apparatus according to claim 1, wherein the controlling device applies the voltage between the first contactor and the second contactor and inspects the insulating state between the first wiring pattern and the second wiring pattern, in a state in which a first diode is inserted between the first contactor and the second contactor in a first direction outside the circuit board and a second diode is inserted between the first contactor and the second contactor in parallel with the first diode in a second direction which is opposite to the first direction outside the circuit board.

3. The circuit board inspection apparatus according to claim 1, further comprising a switching circuit disposed between the first contactor and the second contactor outside the circuit board, and configured to switch between a first state in which the forward current flows in the diode inserted between the first contactor and the second contactor outside the circuit board to form a diversion circuit between the first contactor and the second contactor, and a second state in which the diversion circuit is blocked between the first contactor and the second contactor, wherein
in a situation in which the first state is selected by the switching circuit, the controlling device applies the voltage between the first contactor and the second contactor in the state in which the forward bias is applied to the diode inserted between the first contactor and the second contactor, and inspects the insulating state between the first wiring pattern and the second wiring pattern in such a manner that the potential difference between the first contactor and the second contactor is equal to the potential difference between ends of the diode when the forward current flows in the diode.

4. The circuit board inspection apparatus according to claim 3, wherein
in the switching circuit, in the first state, a first diode is inserted between the first contactor and the second contactor in a first direction and a second diode is inserted between the first contactor and the second contactor in parallel with the first diode in a second direction which is opposite to the first direction, and
the controlling device applies the voltage between the first contactor and the second contactor in the situation in which the first state is selected by the switching circuit, thereby applying the forward bias to one of the first diode and the second diode, and inspects the insulating state between the first wiring pattern and the second wiring pattern in such a manner that the potential difference between the first contactor and the second contactor is equal to the potential difference between ends of the one diode when the forward current flows in the one diode.

5. The circuit board inspection apparatus according to claim 1, further comprising a switching circuit disposed between a plurality of contactors including the first contactor and second contactor outside the circuit board, and configured to switch between a first state in which the forward current flows in each diode disposed between respective one of a plurality of contactor pairs regarding the plurality of contactors to form a diversion circuit between the respective one of the plurality of contactor pairs, and a second state in which the diversion circuit is blocked between the respective one of the plurality of contactor pairs, wherein
in a situation in which the first state is selected by the switching circuit, the controlling device applies the voltage between one of the plurality of contactor pairs in the state in which the forward bias is applied to the each diode inserted between the respective one of the plurality of contactor pairs, and inspects an insulating state between two wiring patterns connected to respective two inspection points associated with the one contactor pair.

6. The circuit board inspection apparatus according to any one of claims 3 to 5, further comprising a third contactor configured to be brought into contact with a third inspection on the circuit board, the third inspection point being not electrically connected to the electronic component, wherein
the controlling device applies the voltage between the first contactor and the third contactor while the first state is continued, and inspects an insulating state between the first wiring pattern connected to the first inspection point and a third wiring pattern connected to the third inspection point.

7. The circuit board inspection apparatus according to claim 5, wherein the switching circuit has a switch configured to simultaneously switch between first state and the second state for the plurality of contactor pairs.

8. The circuit board inspection apparatus according to any of claims 3 to 7, wherein the first wiring pattern and the second wiring pattern are connected via an internal diode inside the electronic component, and the controlling device performs conduction inspection between the first inspection point and the second inspection point in a situation in which the second state is selected by the switching circuit.

9. A circuit board inspection tool used in performing electrical inspection of wiring patterns formed on a circuit board with a built-in electronic component, said circuit board inspection tool comprising:
a first contactor configured to be brought into contact with a first inspection point on the circuit board, the first inspection point being electrically connected to a first terminal of the electronic component;
a second contactor configured to be brought into contact with a second inspection point on the circuit board, the second inspection point being electrically connected to a second terminal of the electronic component; and
a diversion circuit having a diode inserted between the first contactor and the second contactor outside the circuit board, and configured to set a potential difference between the first contactor and the second contactor to be equal to a potential difference between ends of the diode, when forward bias is applied to the diode due to application of voltage between the first contactor and the second contactor by using a power supply and forward current flows in the diode.

10. A circuit board inspection method of performing electrical inspection of wiring patterns formed on a circuit board with a built-in electronic component, said circuit board inspection method comprising:
a) a step of forming a first state in which a diversion circuit is configured outside the circuit board, the diversion circuit having a diode inserted between a first contactor and a second contactor, the first contactor being configured to be brought into contact with a first inspection point on the circuit board, the first inspection point being electrically connected to a first terminal of the electronic component, the second contactor being configured to be brought into contact with a second inspection point on the circuit board, the second inspection point being electrically connected to a second terminal of the electronic component; and
b) a step of applying voltage between the first contactor and the second contactor by using a power supply in such a manner that a potential difference between the first contactor and the second contactor is equal to a potential difference between ends of the diode when forward current flows in the diode due to application of forward bias to the diode of the diversion circuit, thereby inspecting an insulating state between a first wiring pattern connected to the first inspection point and a second wiring pattern connected to the second inspection point.

11. The circuit board inspection method according to claim 10, further comprising:
c) a step of applying voltage between the first contactor and a third contactor configured to be brought into contact with a third inspection point on the circuit board, the third inspection point being not electrically connected to the electronic component, in a situation in which the first state is maintained, thereby inspecting an insulating state between the first wiring pattern connected to the first inspection point and a third wiring pattern connected to the third inspection point.

12. The circuit board inspection method according to claim 10 or 11, wherein
the first wiring pattern and the second wiring pattern are connected via an internal diode inside the electronic component, and
said circuit board inspection method further comprises:
d) a step of forming a second state in which the diversion circuit is blocked; and
e) a step of performing conduction inspection between the first inspection point and the second inspection point in the second state.
